# DEMANDE DE BREVET EUROPEEN

(11) **EP 0 854 522 A1**
(43) Date de publication de la demande: **22.07.1998**
(21) Numéro de dépôt: 98400057.0
(22) Date de dépôt: 14.01.1998
(51) Int. Cl.: H01L 31/108

(54) **Photodétecteur métal-semiconducteur-métal**

(30) Priorité: 17.01.1997 FR 9700464
(71) Demandeur: FRANCE TELECOM, 75015 Paris (FR)
(72) Inventeur: Scavennec, André, 75013 Paris (FR); Temmar, Abdelkader, 31000 Organ (DZ)
(74) Mandataire: Texier, Christian

(57) **Abrégé**

Photodétecteur métal - semiconducteur - métal comportant une couche absorbante, une couche barrière de plus grande énergie de bande interdite sur laquelle sont déposées les électrodes de type Schottky et une couche de transition de composition graduelle, caractérisé en ce qu'il comporte un plan de dopage situé au voisinage de la séparation entre la couche de transition de composition graduelle et la couche absorbante.

## Description

La présente invention est relative aux photodétecteurs de type métal - semiconducteur - métal (MSM), et plus particulièrement aux composants comportant entre la couche photosensible et les contacts métalliques une couche semiconductrice destinée à augmenter la hauteur de barrière schottky.

L'invention s'applique notamment avantageusement aux photodétecteurs en AlInAs/GaInAs sur substrat d'InP utilisés aux longueurs d'onde de 1,3 et 1,55 µm.

Les photodétecteurs de type MSM sur substrat de GaAs présentent des caractéristiques de fonctionnement (courant d'obscurité, rapidité, sensibilité) tout fait satisfaisantes et une compatibilité technologique parfaite avec les transistors à effet de champ de type MESFET. Ce type de composants est notamment développé sous forme de photorécepteurs intégrés et plus particulièrement de barrettes monolithiques de photorécepteurs. On pourra à cet égard avantageusement se référer à :
- [1] J. Choi et al., "High-performance high-yield, uniform 32-channel optical receiver array", OFC'96 Technical Digest, pp. 309-310.

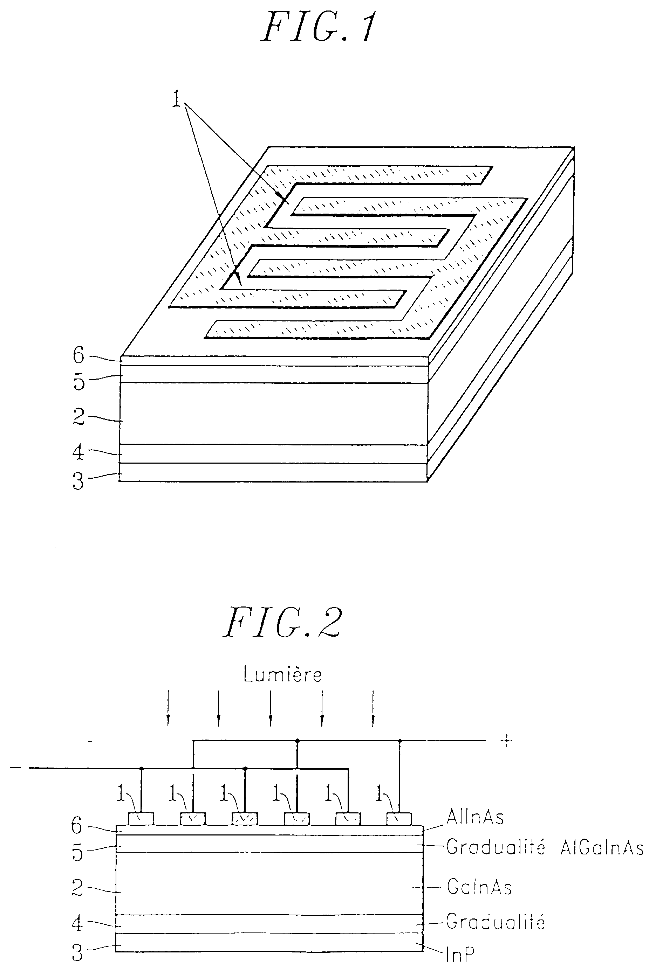

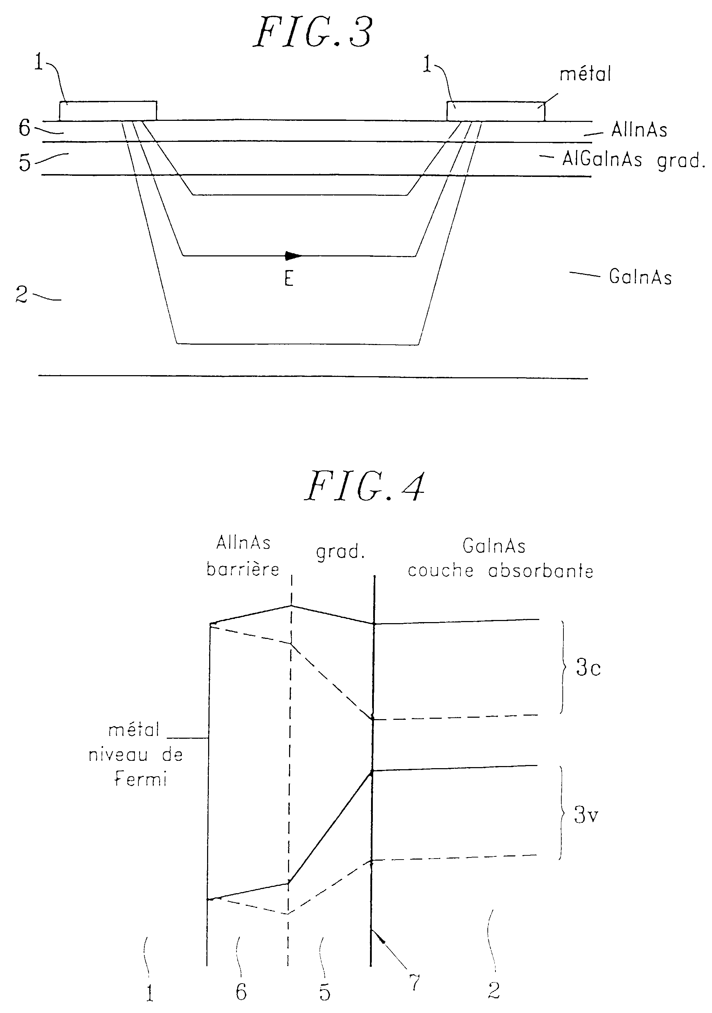

Le GaAs n'étant pas photosensible à 1,3 et 1,55 µm, divers laboratoires ont entrepris d'étudier des photodétecteurs MSM possédant une couche absorbante 2 en GaInAs. Ainsi qu'illustré sur les figures 1 et 2, ces photodétecteurs sont généralement constitués d'un empilement de plusieurs couches épitaxiées sur un substrat 3 de phosphure d'indium (InP). Au-dessus d'une éventuelle couche tampon 4 destinée à éloigner la zone active du composant des défauts de surface du substrat, on trouve la couche active 2 photosensible en GaInAs, puis une couche de transition de composition graduelle en AlGaInAs 5 et enfin la couche barrière 6 en AlInAs. La couche de composition graduelle peut être obtenue de différentes façons, par variation continue de composition ou par juxtaposition de plusieurs fines couches de compositions données, par exemple.

Deux peignes d'électrodes 1 très fines (<1 µm de largeur), interdigitées avec un faible espacement (environ 1 à 3 µm) sont ensuite déposés sur la couche barrière 6. Ces électrodes 1 constituent avec le matériau semiconducteur des jonctions de type Schottky, collectant les porteurs créés par l'absorption de photons dans le semiconducteur.

Des réalisations en ce sens ont notamment été présentées dans :
[2] H.T. Griem et al., "Long-wavelength (1.0-1.6 µm) In_{0.52}Al_{0.48}As/In_{0.53} (GaₓAl₁₋ₓ)_{0.47} As/In_{0.53}Ga_{0.47}As metal-semiconductor-metal photodetector", Appl. Phys. Lett. 56 (11), 12 March 1990, pp. 1067-1068,
[3] M.C. Hargis et al., "Temporal and Spectral Characteristics of Back-Illuminated InGaAs Metal-Semiconductor-Metal Photodetectors", IEEE Photon. Technol. Lett. Vol 8 (1996), No. 1, pp. 110-112.

A part le substrat généralement dopé au fer (Fe) pour le rendre semi-isolant, l'ensemble des couches 3, 4, 5 et 6 n'est généralement pas dopé. Il convient de noter que d'autres matériaux ont été mentionnés dans la littérature pour réaliser la couche barrière 6, comme l'InP non dopé, de type p ou semi-isolant (dopé Fe). On pourra à cet égard se référer à :
[4] C.X. Shi et al., "High-performance Undoped InP/n-In_{0.53}Ga_{0.47}As MSM Photodetectors Grown by LP-MOVPE", IEEE-Trans. Electron. Dev. Vol. 39, No. 5, 5 May 1992, pp. 1028-1030,
[5] R.H. Yuang et al., "High-Performance large-Area InGaAs MSM Photodetectors with a Pseudomorphic InGaP Cap Layer", IEEE Photon. Technol. Lett. Vol 7, No. 8, (1995), pp. 914-916.

Dans la structure des figures 1 et 2, la couche 5 de transition en AlGaInAs a pour rôle d'éliminer le piégeage des porteurs aux hétérojonctions AlInAs/GaInAs ; la gradualité de composition permet d'assurer une transition progressive des bandes de conduction et de valence du GaInAs à celles de l'AlInAs. Toutefois, il est nécessaire d'appliquer une tension importante pour que les barrières s'opposant à la collection des électrons et trous au niveau des contacts s'effacent complètement.

On a représenté sur la figure 3 les lignes du champ électrique E dans un composant du type de celui illustré sur les figures 1 et 2.

En régime normal, les deux jonctions métal/semiconducteur sont polarisées l'une en direct, l'autre en inverse.

L'application d'une tension de polarisation élevée, nécessaire pour obtenir une grande bande passante, est bien entendu néfaste à l'obtention d'un faible courant d'obscurité, ce qui dégrade les performances d'ensemble du détecteur. Par ailleurs, la fiabilité se trouve certainement dégradée dans ce dispositif où les champs électriques les plus élevés sont en surface et concernent l'ensemble de la superficie du photodétecteur. Enfin, l'emploi de tensions plus élevées que ne le nécessite le bon fonctionnement des circuits électroniques associés est toujours pénalisant, du point de vue de la consommation du module de réception.

Dans le cas particulier des photodiodes AlInAs/GaInAs de dopage résiduel de type n pour la couche 2 de GaInAs, c'est la configuration des bandes du côté de l'électrode 1 positive qui joue un rôle prépondérant. A cette électrode 1 sont collectés les électrons et c'est donc la discontinuité des bandes de conduction (0,55 eV) qui fixe la tension à appliquer. Par exemple, pour une couche de transition de 200 nm, il faudra un champ électrique de 0,55/200 V/nm soit 27,5 kV/cm pour éliminer la barrière s'opposant à la collection des électrons. Compte tenu du dopage résiduel de la couche absorbante 2 et de la distance entre les électrodes 1 qui est typiquement de 1 à 2 µm, il est difficile d'atteindre de tels champs à faible tension (à 5 V de polarisation le champ apporté par la tension externe est encore négligeable). Un champ plus faible pourrait suffire en choisissant une couche de transition plus épaisse, mais cela se ferait au détriment de la rapidité globale du dispositif, puisque la zone photosensible se retrouverait plus éloignée des électrodes. En pratique, et pour une couche absorbante 2 de 1 à 2 µm d'épaisseur (nécessaire pour une bonne absorption à 1,3 et 1,5 µm) et pour des électrodes espacées de 2 µm, il convient d'appliquer environ 15 V afin d'obtenir des caractéristiques satisfaisantes de bande passante. Pour des tensions inférieures, un piégeage des porteurs se produit, limitant la bande passante et se traduisant par des traînées très longues dans les réponses impulsionnelles.

Un but de l'invention est de proposer une structure de photodiode de type métal-semiconducteur-métal permettant un fonctionnement avec de faibles tensions de polarisation.

Elle propose à cet effet une structure semblable à celles décrites en référence aux figures 1 et 2, dont on améliore le fonctionnement par l'introduction d'un plan de dopage au voisinage immédiat de la zone de transition entre la couche photosensible et la couche de composition graduelle. Ce plan de dopage permet de modifier la structure de bande du composant et de réduire en particulier le champ électrique nécessaire pour obtenir une collection satisfaisante des porteurs.

Ainsi, l'invention concerne un photodétecteur métal - semiconducteur - métal comportant une couche absorbante, une couche barrière de plus grande énergie de bande interdite sur laquelle sont déposées les électrodes de type Schottky et une couche de transition de composition graduelle, caractérisé en ce qu'il comporte un plan de dopage situé au voisinage de la séparation entre la couche de transition de composition graduelle et la couche absorbante.

D'autres caractéristiques et avantages de l'invention ressortiront encore de la description qui suit. Cette description est purement illustrative et non limitative. Elle doit être lue en regard des dessins annexés sur lesquels :
. les figures 1 et 2, déjà analysées, sont des représentations schématiques respectivement en perspective et en coupe d'une photodiode MSM conforme à un art antérieur connu ;
. la figure 3, également déjà analysée, est une représentation schématique en coupe du composant des figures 1 et 2, sur laquelle on a également porté les lignes de champ électrique dans le composant, pour une paire d'électrodes ;
. la figure 4 est un graphe sur lequel on a porté les niveaux d'énergie de bandes de conduction et de valence dans une photodiode MSM conforme à un mode de réalisation possible pour l'invention.

Sur la figure 4, seule la partie correspondant à l'électrode polarisée positivement a été représentée.

Les niveaux d'énergie de bandes de conduction BC et de valence BV représentés en traits pointillés sur cette figure 4 correspondent à ceux de la structure des figures 1 à 3 ; ceux représentés en traits pleins correspondent à la même structure dans laquelle on a introduit un plan de dopage 7 entre la couche absorbante 2 et la couche de transition graduelle.

On constate sur cette figure 4 que l'introduction du plan de dopage 7 permet l'élimination de la barrière de potentiel dans la bande de conduction, ce qui se traduit par une amélioration du fonctionnement aux tensions de polarisation modérées (meilleure collection à faible éclairement, ce qui doit se traduire en transmission numérique par un seuil de réception amélioré).

Les niveaux d'énergie sur cette figure 4 correspondent au cas d'un dopage résiduel de type n voisin de 10¹⁵/cm³.

Il importe de déterminer précisément la charge du plan de dopage 7 afin d'éviter une situation de piégeage des trous au niveau du contact polarisé négativement. Cette détermination s'effectue à partir de l'équation de Poisson qui régit la dépendance du champ électrique dans une structure en fonction des charges (dE/dx = qN/ε). La charge est fonction du dopage résiduel caractéristique de la technique d'épitaxie utilisée, de la répartition de la différence d'énergie de bande interdite entre la bande de conduction et celle de valence (environ 70 % - 30 % pour le système AlInAs/GaInAs), de l'épaisseur de la zone de transition et de la géométrie du dispositif. En supposant des matériaux à très faibles dopage résiduel de type n (de l'ordre de 10¹⁵/cm³), une épaisseur de l'ordre de 2 pm pour la couche absorbante 2, un espacement entre électrodes de 2 µm et une épaisseur de 200 nm pour l'épaisseur de la zone de transition 3, la charge à introduire dans le plan est un dopage de type p de l'ordre de 10¹¹/cm².

Cette charge permet de compenser le champ initial associé à la gradualité de bande de conduction dans la zone-de transition 5. Ainsi, grâce au plan de dopage 7, on dispose d'une structure qui collecte correctement les porteurs de charge.

Le plan de dopage 7 est de type p, car le dopage résiduel est de type n et, à un moindre degré, parce que la discontinuité de bande de conduction entre AlInAs et GaInAs est supérieure à celle de la bande de valence. La valeur de la charge dépend de la géométrie du dispositif et des dopages résiduels des couches épitaxiées.

On notera par ailleurs que, en supposant nul le dopage des couches épitaxiées, le diagramme de bande sans plan de dopage fait apparaître deux barrières, l'une liée à une différence de niveau d'énergie en bande de conduction, l'autre liée à une différence de niveau d'énergie en bande de valence. L'application d'une tension de polarisation permet d'éliminer la barrière liée à la discontinuité en bande de valence bien avant celle liée à ΔEc. Dans la pratique, l'effet du dopage résiduel l'emporte.

La réalisation d'une photodiode du type de celle qui vient d'être décrite s'effectue aux moyens des techniques classiques d'épitaxie, par Jets Moléculaires par exemple.

Pour une présentation de ces techniques, on pourra avantageusement se référer à la publication suivante
[6] A. Temmar et al., "Photodiode de type métal-semiconducteur-métal (MSM) sur substrat d'InP", Journal de Physique III (1996).

Sur le substrat 3 - qui peut être préférentiellement un substrat d'InP - est d'abord épitaxiée une couche tampon en AlInAs d'une épaisseur de 200 nm, puis une couche 4 de composition graduelle allant de AlInAs à GaInAs et présentant une épaisseur de 200 nm. Cette couche graduelle 4 sert à repousser d'éventuels porteurs de charge vers la couche active 2 et à éviter ainsi tout piégeage de charges près de l'interface. Puis la couche active photosensible 2 en GaInAs est épitaxiée, avec une épaisseur de 1 à 2 µm afin d'absorber une majeure partie des photons incidents. Sur cette couche active est déposée la couche de composition graduelle 5, avec une composition qui varie du GaInAs à AlInAs sur une épaisseur de 100 à 300 nm typiquement. Au début de la croissance de cette couche, une charge de type p est introduite sous forme d'un plan de dopage 7, couche très mince et très dopée (10¹¹/cm²). Ce plan de dopage peut être obtenu par le dépôt d'une fraction de monocouche d'un dopant p (béryllium par exemple) ou par dopage du AlGaInAs à un niveau voisin de 10¹⁸cm⁻³, sur quelques 20 nm. Il est à noter que ce plan de dopage 7 peut également être introduit à la fin de la croissance de la couche absorbante.

On notera qu'en variante, la zone de transition 5 de composition graduelle peut être réalisée, par juxtaposition de plusieurs couches d'énergie de bande interdite différentes et croissantes de la couche photosensible à la couche barrière 6 en AlInAs, ou bien par modulation de période d'une structure à superréseau.

Après dépôt de la couche barrière 6, par exemple en AlInAs (épaisseur de 30 nm), on dépose, par des techniques également connues en elles-mêmes et décrites par exemple dans la publication [6] précitée, les électrodes 1 de la photodiode.

Le matériau AlInAs, avec une hauteur de barrière Schottky très voisine pour les électrons et pour les trous, apparaît être pour les barrières 6 un matériau d'un meilleur choix que l'InP. Cependant, l'invention s'applique bien entendu également dans le cas de structures dont les barrières sont en InP.

## Revendications

1. Photodétecteur métal - semiconducteur - métal comportant une couche absorbante, une couche barrière de plus grande énergie de bande interdite sur laquelle sont déposées les électrodes de type Schottky et une couche de transition de composition graduelle, caractérisé en ce qu'il comporte un plan de dopage situé au voisinage de la séparation entre la couche de transition de composition graduelle et la couche absorbante.

2. Photodétecteur selon la revendication 1, caractérisé en ce que le plan de dopage est de type p.

3. Photodétecteur selon l'une des revendications précédentes, caractérisé en ce que la couche absorbante est en GaInAs, la couche de transition de composition graduelle étant en AlGaInAs.

4. Photodétecteur selon la revendication 3, caractérisé en ce qu'il comporte, sur un substrat, l'empilement de couches suivantes :
- une couche tampon en AlInAs,
- une couche de composition graduelle en AlGaInAs,
- une couche active d'absorption en GaInAs,
- un plan de dopage de type p,
- une couche de composition graduelle en AlGaInAs,
- une couche barrière sur laquelle sont déposées des électrodes.

5. Photodétecteur selon l'une des revendications précédentes, caractérisé en ce que la couche barrière est en AlInAs.

6. Photodétecteur selon l'une des revendications 1 à 4, caractérisé en ce que la couche barrière est en InP.

7. Photodétecteur selon l'une des revendications précédentes, caractérisé en ce que le substrat est un substrat d'InP.
